# EUROPEAN PATENT APPLICATION

(11) **EP 2 413 458 A1**
(43) Date of publication of application: **01.02.2012**
(21) Application number: 11166903.2
(22) Date of filing: 20.05.2011
(51) Int. Cl.: H02J 7/00, H01H 9/54, H01M 10/50

(54) **Battery heating circuit**

(30) Priority: 30.07.2010 CN 201010245288; 30.08.2010 CN 201010274785; 23.12.2010 CN 201010603471
(71) Applicant: Byd Company Limited, Shenzhen 518118 (CN)
(72) Inventor: Xu, Wenhui, 518118, Shenzhen Guangdong (CN); Han, Yaochuan, 518118, Shenzhen Guangdong (CN); Feng, Wei, 518118, Shenzhen Guangdong (CN); Yang, Qinyao, 518118, Shenzhen Guangdong (CN); Xia, Wenjin, 518118, Shenzhen Guangdong (CN); Ma, Shibin, 518118, Shenzhen Guangdong (CN)
(74) Representative: Meissner, Bolte & Partner

(57) **Abstract**

A battery heating circuit, comprising a switch unit (1), a switching control module (100), a damping element R1, an energy storage circuit, an energy limiting circuit, and an energy control unit for energy storage circuit, wherein, the energy storage circuit is connected with the battery, and comprises a current storage element L1 and a charge storage element C1; the damping element R1, switch unit (1), current storage element L1, and charge storage element C1 are connected in series; the switching control module (100) is connected with the switch unit (1), and is designed to control ON/OFF of the switch unit (1), so that the energy can flow to and fro between the battery and the energy storage circuit when the switch unit (1) switches on; the energy limiting circuit is designed to limit the magnitude of current flowing from the energy storage circuit to the battery; the energy control unit for energy storage circuit is connected with the energy storage circuit, and is designed to control the energy conversion in the energy storage circuit to a preset value after the switching control module (100) controls the switch unit (1) to switch on and then switch off. Using the heating circuit provided in the present invention, safety problem caused by overcurrent in the heating loop can be avoided, and therefore the battery can be protected effectively.

## Description

### Technical Field of the Invention

The present invention pertains to electric and electronic field, in particular to a battery heating circuit.

### Background of the Invention

In view cars have to run under complex road conditions and environmental conditions or some electronic devices are used under harsh environmental conditions, the battery, which serves as the power supply unit for electric motor cars or electronic devices, must be adaptive to these complex conditions. In addition, besides these conditions, the service life and charge/discharge cycle performance of the battery must be taken into consideration; especially, when electric motor cars or electronic devices are used in low temperature environments, the battery is required to have outstanding low temperature charge/discharge performance and higher input/output power performance.

Generally speaking, under low temperature conditions, the resistance of the battery will increase, and so will the polarization; therefore, the capacity of the battery will be reduced.

To keep the capacity of the battery and improve the charge/discharge performance of the battery under low temperature conditions, the present invention provides a battery heating circuit.

### Summary of the Invention

The objective of the present invention is to provide a battery heating circuit, in order to solve the problem of decreased capacity of the battery caused by increased resistance and polarization of the battery under low temperature conditions.

A battery heating circuit is provided, comprising a switch unit, a switching control module, a damping element R1, an energy storage circuit, an energy limiting circuit, and an energy control unit for energy storage circuit, wherein, the energy storage circuit is connected with the battery, and comprises a current storage element L1 and a charge storage element C1; the damping element R1, switch unit, current storage element L1, and charge storage element C1 are connected in series; the switching control module is connected with the switch unit, and is designed to control ON/OFF of the switch unit, so that the energy can flow to and fro between the battery and the energy storage circuit when the switch unit switches on; the energy limiting circuit is designed to limit the magnitude of current flowing from the energy storage circuit to the battery; the energy control unit for energy storage circuit is connected with the energy storage circuit, and is designed to control the energy conversion in the energy storage circuit to a preset value after the switching control module controls the switch unit to switch on and then switch off.

The heating circuit provided in the present invention can improve the charge/discharge performance of the battery; in addition, since the energy storage circuit is connected with the battery in series in the heating circuit, safety problem caused by over current as failures and short circuit of the switch unit can be avoided when the battery is heated due to the existence of the charge storage elements C1 connected in series, and therefore the battery can be protected effectively.

Other characteristics and advantages of the present invention will be further elaborated in detail in the embodiments hereafter,

### Brief Description of the Drawings

The accompanying drawings, as a part of this description, are provided here to facilitate further understanding on the present invention, and are used in conjunction with the following embodiments to explain the present invention, but shall not be comprehended as constituting any limitation to the present invention. In the figures:
Figure 1 is a schematic diagram of the battery heating circuit provided in the present invention;
Figure 2 is a schematic diagram of an embodiment of the switch unit shown in Figure 1;
Figure 3 is a schematic diagram of an embodiment of the switch unit shown in Figure 1;
Figure 4 is a schematic diagram of a preferred embodiment of the battery heating circuit provided in the present invention, wherein, the energy control unit for energy storage circuit comprises a polarity inversion unit;
Figure 5 is a schematic diagram of a preferred embodiment of the battery heating circuit provided in the present invention, wherein, the energy control unit for energy storage circuit comprises an electricity recharge unit;
Figure 6 is a schematic diagram of an embodiment of the polarity inversion unit shown in Figure 4;
Figure 7 is a schematic diagram of an embodiment of the polarity inversion unit shown in Figure 4;
Figure 8 is a schematic diagram of an embodiment of the polarity inversion unit shown in Figure 4;
Figure 9 is a schematic diagram of an embodiment of the first DC-DC module shown in Figure 8;
Figure 10 is a schematic diagram of an embodiment of the electricity recharge unit shown in Figure 5;
Figure 11 is a schematic diagram of a preferred embodiment of the battery heating circuit provided in the present invention, wherein, the energy control unit for energy storage circuit comprises a polarity inversion unit and an electricity recharge unit;
Figure 12 is a schematic diagram of a preferred embodiment of the battery heating circuit provided in the present invention, wherein, the energy control unit for energy storage circuit comprises a DC-DC module;
Figure 13 is a schematic diagram of an embodiment of the DC-DC module shown in Figure 12;
Figure 14 is a schematic diagram of an embodiment of the battery heating circuit provided in the present invention;
Figure 15 is a timing sequence diagram of the waveform corresponding to the heating circuit shown in Figure 14;
Figure 16 is a schematic diagram of an embodiment of the battery heating circuit provided in the present invention.

### Detailed Description of the Embodiments

Hereafter the embodiments of the present invention will be elaborated in detail, with reference to the accompanying drawings. It should be appreciated that the embodiments described here are only provided to describe and explain the present invention, but shall not be deemed as constituting any limitation to the present invention.

It is noted that, unless otherwise specified, where mentioned hereafter in this description, the term "switching control module" refers to any controller that can output control commands (e.g., pulse waveform) under preset conditions or at preset times and thereby controls the switch unit connected to it to switch on or switch off accordingly, for example, the switching control module can be a PLC; where mentioned hereafter in this description, the term "switch" refers to a switch that enables ON/OFF control by means of electrical signals or enables ON/OFF control on the basis of the characteristics of the element or component, which is to say, the switch can be either a one-way switch (e.g., a switch composed of a two-way switch and a diode connected in series, which can switch on in one direction) or a two-way switch (e.g., a Metal Oxide Semiconductor Field Effect Transistor (MOSFET) or an IGBT with an anti-parallel freewheeling diode); where mentioned hereafter in this description, the term "two-way switch" refers to a switch that can switch on in two ways, which can enable ON/OFF control by means of electrical signals or enable ON/OFF control on the basis of the characteristics of the element or component, for example, the two-way switch can be a MOSFET or an IGBT with an anti-parallel freewheeling diode; where mentioned hereafter in this description, the term "one-way semiconductor element" refers to a semiconductor element that can switch on in one direction, such as an diode; where mentioned hereafter in this description, the term "charge storage element" refers to any device that can enable charge storage, such as a capacitor; where mentioned hereafter in this description, the term "current storage element" refers to any device that can store current, such as an inductor; where mentioned hereafter in this description, the term "forward direction" refers to the direction in which the energy flows from the battery to the energy storage circuit, and the term "reverse direction" refers to the direction in which the energy flows from the energy storage circuit to the battery; where mentioned hereafter in this description, the term "battery" comprises primary battery (e.g., dry battery or alkaline battery, etc.) and secondary battery (e.g., lithium-ion battery, nickel-cadmium battery, nickel-hydrogen battery, or lead-acid battery, etc.); where mentioned hereafter in this description, the term "damping element" refers to any device that inhibits current flow and thereby enables energy consumption, such as a resistor, etc.; where mentioned hereafter in this description, the term "main loop" refers to a loop composed of battery and damping element, switch unit and energy storage circuit connected in series.

It should be noted specially that in view different types of batteries have different characteristics, in the present invention, the "battery" may refer to an ideal battery that does not have internal parasitic resistance and parasitic inductance or has very low internal parasitic resistance and parasitic inductance, or may refer to a battery pack that has internal parasitic resistance and parasitic inductance; therefore, those skilled in the art should appreciate that if the battery is an ideal battery that does not have internal parasitic resistance and parasitic inductance or has very low internal parasitic resistance and parasitic inductance, the damping element R1 refers to a damping element external to the battery, and the current storage element L1 refers to a current storage element external to the battery; if the battery is a battery pack that has internal parasitic resistance and parasitic inductance, the damping element R1 refers to a damping element external to the battery, or refers to the parasitic resistance in the battery pack; likewise, the current storage element L2 refers to a current storage element external to the battery, or refers to the parasitic inductance in the battery pack.

To ensure the normal service life of the battery, the battery can be heated under low temperature condition, which is to say, when the heating condition is met, the heating circuit is controlled to start heating for the battery; when the heating stop condition is met, the heating circuit is controlled to stop heating.

In the actual application of battery, the battery heating condition and heating stop condition can be set according to the actual ambient conditions, to ensure normal charge/discharge performance of the battery.

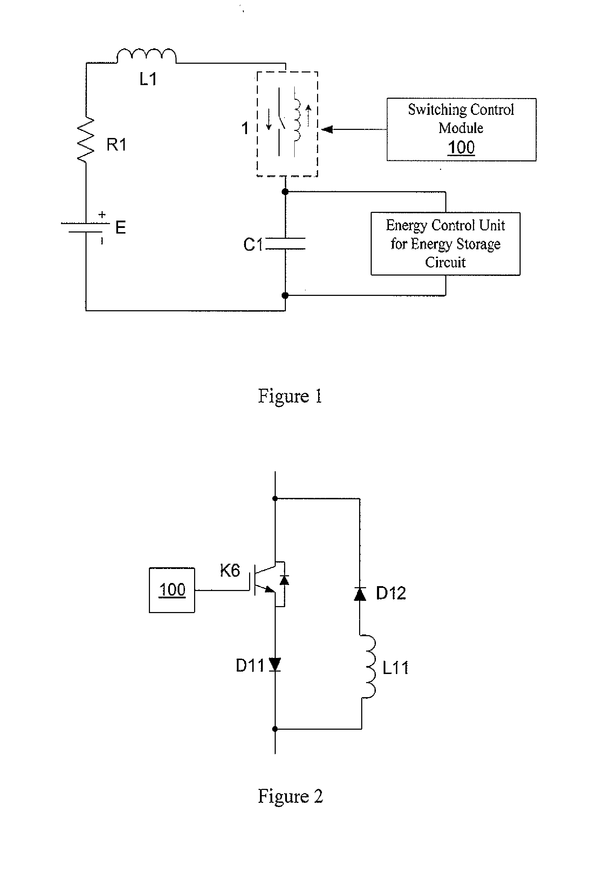

To heat up a battery E in low temperature environment, the present invention provides a heating circuit for battery E; as shown in Figure 1, the battery heating circuit comprises a switch unit 1, a switching control module 100, a damping element R1, an energy storage circuit, an energy limiting circuit, and an energy control unit for energy storage circuit, wherein, the energy storage circuit is connected with the battery, and comprises a current storage element L1 and a charge storage element C1; the damping element R1, switch unit 1, current storage element L1, and charge storage element C1 are connected in series; the switching control module 100 is connected with the switch unit 1, and is designed to control ON/OFF of the switch unit 1, so that the energy can flow to and fro between the battery and the energy storage circuit when the switch unit 1 switches on; the energy limiting circuit is designed to limit the magnitude of current flowing from the energy storage circuit to the battery; the energy control unit for energy storage circuit is connected with the energy storage circuit, and is designed to control the energy conversion in the energy storage circuit to a preset value after the switching control module 100 controls the switch unit 1 to switch on and then switch off.

In view different types of batteries E have different characteristics, if the resistance value of the parasitic resistance and the self-inductance of the parasitic inductance in the battery E are high, the damping element R1 can be the parasitic resistance in the battery, and the current storage element L1 can be the parasitic inductance in the battery.

The switch unit 1 is connected in series with the energy storage circuits, when the switch unit 1 switches on, the energy can flows to and fro between the battery E and the energy storage circuits. The switch unit 1 can be implemented in a variety of ways, and the present invention doesn't make any limitation to the implementation of the switch unit. The switch unit 1 may comprise a first one-way branch designed to enable energy flow from the battery to the energy storage circuit and a second one-way branch designed to enable energy flow from the energy storage circuit to the battery; the switching control module 100 is connected to either or both of the first one-way branch and second one-way branch, and is designed to control ON/OFF of the switch unit 1 by controlling ON/OFF of the connected branches. The energy limiting circuit may comprise a current storage element L11, the current storage element L11 is connected in series in the second one-way branch, and is used to limit the magnitude of the current flowing to the battery E.

In an embodiment of switch unit 1, as shown in Figure 2, the switch unit 1 may comprise a switch K6, a one-way semiconductor element D11, and a one-way semiconductor element D12, wherein, the switch K6 and the one-way semiconductor element D11 are connected in series with each other to form the first one-way branch; the one-way semiconductor element D12 forms the second one-way branch; the switching control module 100 is connected with the switch K6, to control ON/OFF of the first one-way branch by controlling ON/OFF of the switch K6, The current storage element L11 is connected in series with the one-way semiconductor element D12. In the switch unit 1 shown in Figure 2, when heating is required, the switch K6 can be controlled to switch on; when heating is not required, the switch K6 can be controlled to switch off.

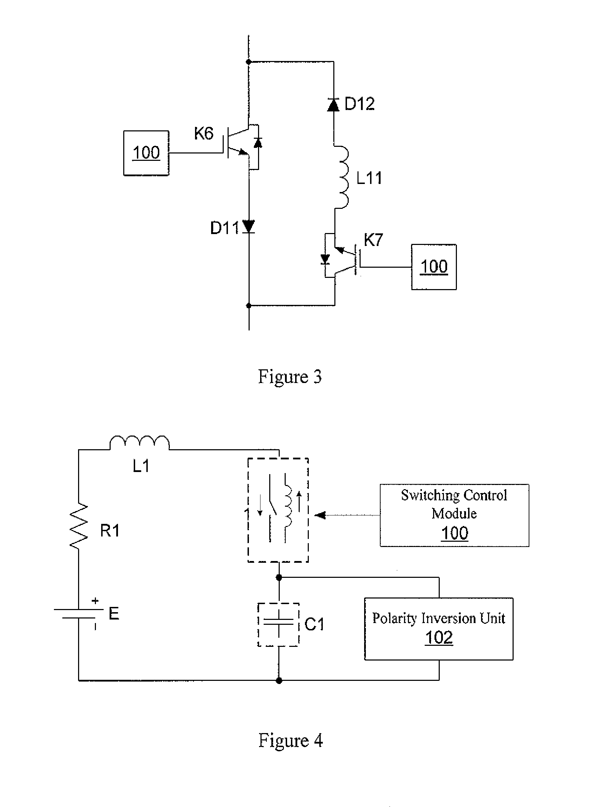

Though the implementation of switch unit 1 shown in Figure 2 enables to-and-fro energy flow along separate branches, it cannot enable energy flow cut-off function in reverse direction. The present invention further puts forward another embodiment of switch unit 1; as shown in Figure 3, the switch unit 1 can further comprise a switch K7 in the second one-way branch, wherein, the switch K7 is connected with the one-way semiconductor element D12 in series, the switching control module 100 is also connected with the switch K7, and is designed to control ON/OFF of the second one-way branch by controlling ON/OFF of the switch K7. Thus, in the switch unit 1 shown in Figure 3, since there are switches (i.e., switch K6 and switch K7) in both one-way branches, energy flow cut-off function in forward direction and reverse direction is enabled simultaneously. The current storage element L11 is connected in series between the one-way semiconductor element D12 and the switch K7, and is used to limit the current flowing to the battery E.

According to the technical solution of the present invention, when the battery E is to be heated up, the switching control module 100 controls the switch unit 1 to switch on, and thereby the battery E and the energy storage circuits are connected in series to form a loop, and the battery E charges the charge storage element C1; when the current of the loop reaches to zero in forward direction after the peak current, the charge storage element C1 begins discharging, and therefore the current flows from the charge storage element C1 back to the battery E; since both the current in forward direction and the current in reverse direction in the loop flow though the damping element R1, the purpose of heating up the battery E is attained by means of the heat generation in the damping element R1. Above charge/discharge process is carried out cyclically. When the temperature of the battery E rises to the heating stop condition, the switching control module 100 can control the switch unit 1 to switch off, and thereby the heating circuit will stop operating.

In the heating process described above, when the current flows from the energy storage circuit back to the battery E, the energy in the charge storage element C1 will not flow back to the battery E completely; ultimately the voltage across the charge storage element C1 is close or equal to the voltage of the battery, and therefore the energy can't flow from the battery E to the charge storage element C1 any more; that phenomenon is adverse to the cyclic operation of the heating circuit. In view of that problem, the heating circuit provided in the present invention further comprises an energy control unit for energy storage circuit, which is designed to control energy in the energy storage circuit to be converted into a preset value when the switch unit 1 switches on and then switches off. At an appropriate time, the switch unit 1 is controlled to switch off, and energy control unit for energy storage circuit is enabled to control the energy in the charge storage element C1. The switch unit 1 can be controlled to switch off at any time in one or more cycles; the switch unit 1 can be controlled to switch off at any time, for example, when the current in the loop is flowing in forward direction/reverse direction, or when the current in the loop is zero or not zero, A specific implementation form of switch unit 1 can be selected, depending on the required cut-off strategy; if the switch unit 1 can be controlled to switch off when the current is flowing in forward direction as required, the implementation form of switch unit 1 shown in Figure 2 can be selected; if the switch unit 1 can be controlled to switch off when the current is either flowing in forward direction or in reverse direction as required, the switch unit 1 which can enable the control of both branches in forward direction and reverse direction shown in Figure 3 can be selected. Preferably, the switching control module 100 is designed to control the switch unit 1 to switch off when the current flowing though the switch unit 1 reaches zero or after zero after the switch unit 1 switches on, so as to improve the working efficiency of the loop. In addition, the disturbance to the entire circuit may be minimized if the switch unit 1 switches off when the current in the loop is zero.

According to an embodiment of the present invention, as shown in Figure 4, the energy control unit for energy storage circuit in the heating circuit provided in the present invention can comprise a polarity inversion unit 102, which is connected with the energy storage circuit, and is designed to invert the voltage polarity of the charge storage element C1 after the switch unit 1 switches on and then switches off, so that the voltage of the charge storage element C1 added in series with the voltage of the battery E; thus, when the switch unit 1 switches on again, the energy in the charge storage element C1 after polarity inversion superposed with the energy in the battery E is discharged, and is charged into the charge storage element C1 again by current flowing in forward direction; thus, the energy in the charge storage element C1 is recycled, and thereby the working efficiency of the heating circuit is improved.

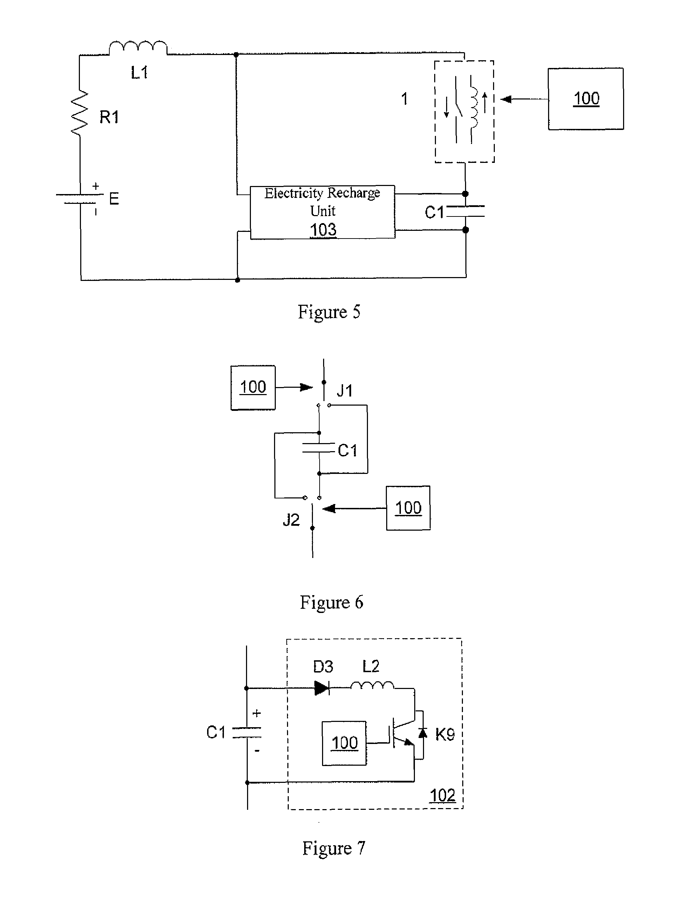

According to another embodiment of the present invention, as shown in Figure 5, the energy control unit for energy storage circuit in the heating circuit provided in the present invention can comprise an electricity recharge unit 103, which is connected with the energy storage circuit, and is designed to transfer the energy in the energy storage circuit to the battery E after the switch unit 1 switches on and then switches off. The purpose of the electricity recharge unit 103 is to recycle the energy in the storage circuit.

As an embodiment of the polarity inversion unit 102 , as shown in Figure 6, the polarity inversion unit 102 comprises a single pole double throw switch J1 and a single pole double throw switch J2 located on the two ends of the charge storage element C1 respectively; the input wires of the single pole double throw switch J1 are connected in the energy storage circuit, the first output wire of the single pole double throw switch J1 is connected with the first pole plate of the charge storage element C1, and the second output wire of the single pole double throw switch J1 is connected with the second pole plate of the charge storage element C1; the input wires of the single pole double throw switch J2 are connected in the energy storage circuit, the first output wire of the single pole double throw switch J2 is connected with the second pole plate of the charge storage element C1, and the second output wire of the single pole double throw switch J2 is connected with the first pole plate of the charge storage element C1; the switching control module 100 is also connected with the single pole double throw switch J1 and single pole double throw switch J2 respectively, and is designed to invert the voltage polarity of the charge storage element C1 by altering the connection relationships between the respective input wires and output wires of the single pole double throw switch J1 and the single pole double throw switch J2.

According to this embodiment, the connection relationships between the respective input wires and output wires of the single pole double throw switch J1 and single pole double throw switch J2 can be set in advance, so that the input wires of the single pole double throw switch J1 are connected with the first output wire of the switch unit K1 and the input wires of the single pole double throw switch J2 are connected with the first output wire of the switch unit K1 when the switch unit K1 switches on; the input wires of the single pole double throw switch J1 are switched to connect with the second output wire of the switch unit K1 and the input wires of the single pole double throw switch J2 are switched to connect with the second output wire of the switch unit K1 under control of the switching control module 100 when the switch unit K1 switches off, and thereby the voltage polarity of the charge storage element C1 is inverted.

As another embodiment of the polarity inversion unit 102, as shown in Figure 7, the polarity inversion unit 102 comprises a one-way semiconductor element D3, a current storage element L2, and a switch K9; the charge storage element C1, current storage element L2, and switch K9 are connected sequentially in series to form a loop; the one-way semiconductor element D3 is connected in series between the charge storage element C1 and the current storage element L2 or between the current storage element L2 and the switch K9; the switching control module 100 is also connected with the switch K9, and is designed to invert the voltage polarity of the charge storage element C1 by controlling the switch K9 to switch on.

According to the above embodiment, when the switch unit 1 switches off, the switch K9 can be controlled to switch on by the switching control module 100, and thereby the charge storage element C1, one-way semiconductor element D3, current storage element L2, and switch K9 form a LC oscillation loop, and the charge storage element C1 discharges through the current storage element L2, thus, the voltage polarity of the charge storage element C1 will be inverted when the current flowing through the current storage element L2 reaches to zero after the current in the oscillation circuit flows through the positive half cycle.

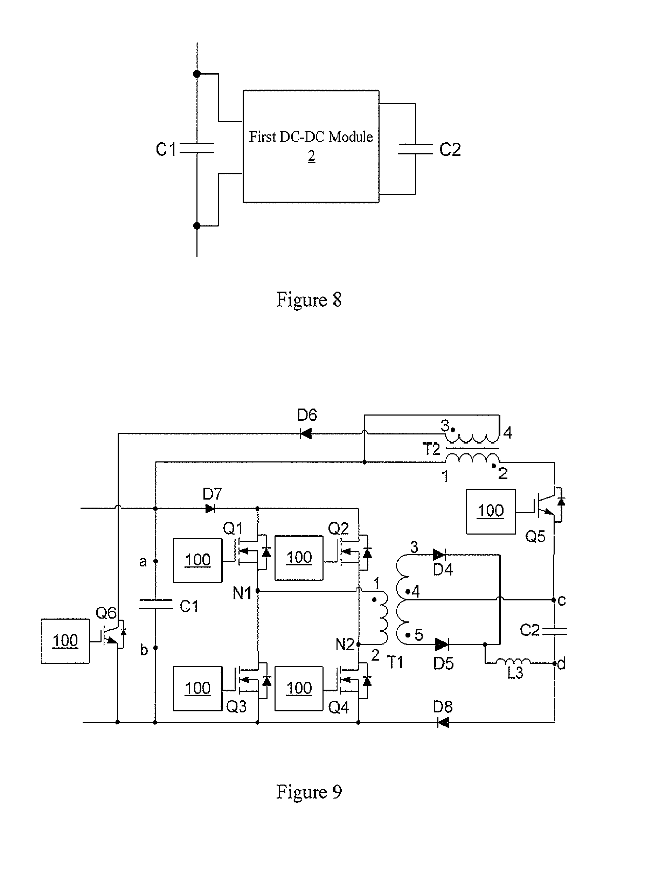

As yet another embodiment of the polarity inversion unit 102, as shown in Figure 8, the polarity inversion unit 102 comprises a first DC-DC module 2 and a charge storage element C2; the first DC-DC module 2 is connected with the charge storage element C1 and the charge storage element C2 respectively; the switching control module 100 is also connected with the first DC-DC module 2, and is designed to transfer the energy in the charge storage element C1 to the charge storage element C2 by controlling the operation of the first DC-DC module 2, and then transfer the energy in the charge storage element C2 back to the charge storage element C1, so as to invert the voltage polarity of the charge storage element C1.

The first DC-DC module 2 is a DC-DC ( direct current to direct current) conversion circuit for voltage polarity inversion commonly used in the field. The present invention doesn't make any limitation to the specific circuit structure of the first DC-DC module 2, as long as the module can accomplish voltage polarity inversion of the charge storage element C1. Those skilled in the art can add, substitute, or delete the elements in the circuit as required.

Figure 9 shows an embodiment of the first DC-DC module 2 provided in the present invention. As shown in Figure 9, the first DC-DC module 2 comprises: a two-way switch Q1, a two-way switch Q2, a two-way switch Q3, a two-way switch Q4, a first transformer T1, an one-way semiconductor element D4, an one-way semiconductor element D5, a current storage element L3, a two-way switch Q5, a two-way switch Q6, a second transformer T2, an one-way semiconductor element D6, an one-way semiconductor element D7, and an one-way semiconductor element D8.

In the embodiment, the two-way switch Q1, two-way switch Q2, two-way switch Q3, and two-way switch Q4 are MOSFETs, and the two-way switch Q5 and two-way switch Q6 are IGBTs.

The Pin 1, 4, and 5 of the first transformer T1 are dotted terminals, and the pin 2 and 3 of the second transformer T2 are dotted terminals.

Wherein, the positive electrode of the one-way semiconductor element D7 is connected with the end 'a' of the charge storage element C1, and the negative electrode of the one-way semiconductor element D7 is connected with the drain electrodes of the two-way switch Q1 and two-way switch Q2, respectively; the source electrode of the two-way switch Q1 is connected with the drain electrode of the two-way switch Q3, and the source electrode of the two-way switch Q2 is connected with the drain electrode of the two-way switch Q4; the source electrodes of the two-way switch Q3 and two-way switch Q4 are connected with the end 'b' of the charge storage element C1 respectively. Thus, a full-bridge circuit is formed, here, the voltage polarity of end 'a' of the charge storage element C1 is positive, while the voltage polarity of end 'b' of the charge storage element Clis negative.

In the full-bridge circuit, the two-way switch Q1, two-way switch Q2 constitute the upper bridge arm, while the two-way switch Q3 and two-way switch Q4 constitute the lower bridge arm. The full-bridge circuit is connected with the charge storage element C2 via the first transformer T1; the pin 1 of the first transformer T1 is connected with the first node N1, the pin 2 of the first transformer T1 is connected with the second node N2, the pin 3 and pin 5 of the first transformer T1 are connected to the positive electrode of the one-way semiconductor element D4 and the positive electrode of the one-way semiconductor element D5 respectively; the negative electrode of one-way semiconductor element D4 and the negative electrode of one-way semiconductor element D5 are connected with one end of the current storage element L3, and the other end of the current storage element L3 is connected with the end 'd' of the charge storage element C2; the pin 4 of the transformer T1 is connected with the end 'c' of the charge storage element C2, the positive electrode of the one-way semiconductor element D8 is connected with the end 'd' of the charge storage element C2, and the negative electrode of the one-way semiconductor element D8 is connected with the end 'b' of the charge storage element C1; here, the voltage polarity of end 'c' of the charge storage element C2 is negative, while the voltage polarity of end 'd' of the charge storage element C2 is positive.

Wherein, the end 'c' of the charge storage element C2 is connected with the emitter electrode of the two-way switch Q5, the collector electrode of the two-way switch Q5 is connected with the pin 2 of the transformer T2, the pin 1 of the transformer T2 is connected with end 'a' of the charge storage element C1, the pin 4 of the transformer T2 is connected with end 'a' of the charge storage element C1, the pin 3 of the transformer T2 is connected with the positive electrode of the one-way semiconductor element D6, the negative electrode of the one-way semiconductor element D6 is connected with the collector electrode of the two-way switch Q6, and the emitter electrode of the two-way switch Q6 is connected with the end 'b' of the charge storage element C2.

Wherein, the two-way switch Q1, two-way switch Q2, two-way switch Q3, two-way switch Q4, two-way switch Q5, and two-way switch Q6 are controlled by the switching control module 100 respectively to switch on and switch off.

Hereafter the working process of the first DC-DC module 2 will be described:
1. After the switch unit 1 switches off, the switching control module 100 controls the two-way switch Q5 and two-way switch Q6 to switch off, and controls the two-way switch Q1 and two-way switch Q4 to switch on at the same time to form phase A; controls the two-way switch Q2 and two-way switch Q3 to switch on at the same time to form phase B. Thus, by controlling the phase A and phase B to switch on alternately, a full-bridge circuit is formed;
2. When the full-bridge circuit operates, the energy in the charge storage element C1 is transferred through the first transformer T1, one-way semiconductor element D4, one-way semiconductor element D5, and current storage element L3 to the charge storage element C2; now, the voltage polarity of end 'c' of the charge storage element C2 is negative, while the voltage polarity of end 'd' of the charge storage element C2 is positive.
3. The switching control module 100 controls the two-way switch Q5 to switch on, and therefore a path from the charge storage element C1 to the charge storage element C2 is formed via the second transformer T2 and the one-way semiconductor element D8, thus, the energy in the charge storage element C2 is transferred back to the charge storage element C1, wherein, some energy will be stored in the second transformer T2, Now, the switching control module 100 controls the two-way switch Q5 to switch off and controls the two-way switch Q6 to switch on, and therefore the energy stored in the second transformer T2 is transferred to the charge storage element C1 by the second transformer T2 and the one-way semiconductor element D6; now, the voltage polarity of the charge storage element C1 is inverted such that end 'a' is negative and end 'b' is positive. Thus, the purpose of inverting the voltage polarity of the charge storage element C1 is attained.

As an embodiment of the electricity recharge unit 103 , the electricity recharge unit 103 comprises a second DC-DC module 3, which is connected with the charge storage element C1 and the battery E respectively; the switching control module 100 is also connected with the second DC-DC module 3, and is designed to control the operation of the second DC-DC module 3, so as to transfer the energy in the charge storage element C1 to the battery E.

The second DC-DC module 3 is a DC-DC (direct current to direct current) conversion circuit for energy transfer commonly used in the field. The present invention doesn't make any limitation to the specific circuit structure of the second DC-DC module 3, as long as the module can transfer the energy in the charge storage element C1. Those skilled in the art can add, substitute, or delete the elements in the circuit as required.

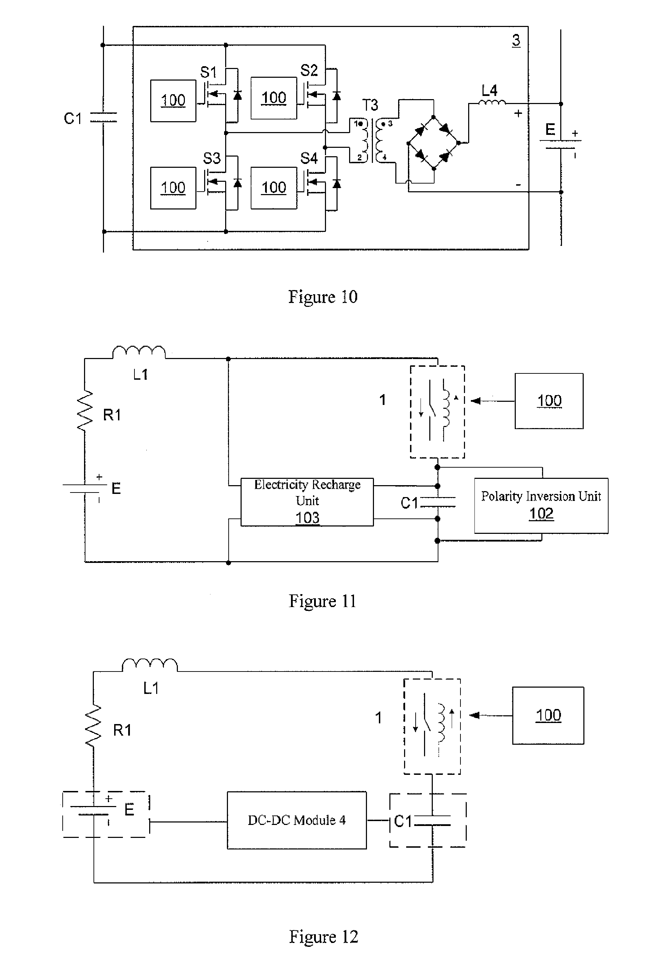

Figure 10 shows an embodiment of the second DC-DC module 3 provided in the present invention. As shown in Figure 10, the second DC-DC module 3 comprises: a two-way switch 51, a two-way switch S2, a two-way switch S3, a two-way switch S4, a third transformer T3, a current storage element L4, and four one-way semiconductor elements. In the embodiment, the two-way switch 51, two-way switch S2, two-way switch S3, and two-way switch S4 are MOSFETs.

Wherein, the pin 1 and pin 3 of the third transformer T3 are dotted terminals; the negative electrodes of two one-way semiconductor elements among the four one-way semiconductor elements are connected into a group and their junction point is connected with the positive pole of the battery E through the current storage element L4; the positive electrodes of the other two one-way semiconductor elements are connected into a group and their junction point is connected with the negative pole of the battery E; in addition, the junction points between the groups are connected with pin 3 and pin 4 of the third transformer T3 respectively, and thereby form a bridge rectifier circuit.

Wherein, the source electrode of the two-way switch S1 is connected with the drain electrode of the two-way switch S3, the source electrode of the two-way switch S2 is connected with the drain electrode of the two-way switch S4, the drain electrodes of the two-way switch S1 and two-way switch S2 are connected with the positive end of the charge storage element C1 respectively, the source electrodes of the two-way switch S3 and two-way switch S4 are connected with the negative end of the charge storage element C1 respectively; thus, a full-bridge circuit is formed.

In the full-bridge circuit, the two-way switch S1 and two-way switch S2 constitute the upper bridge arm, and the two-way switch S3 and two-way switch S4 constitute the lower bridge arm; the pin 1 of the third transformer T3 is connected with the node between two-way switch S1 and two-way switch S3, and the pin 2 of the third transformer T3 is connected with the node between two-way switch S2 and two-way switch S4.

Wherein, the two-way switch S1, two-way switch S2, two-way switch S3, and two-way switch S4 are controlled by the switching control module 100 respectively to switch on and switch off.

Hereafter the working process of the second DC-DC module 3 will be described:
1. After the switch unit 1 switches off, the switching control module 100 controls the two-way switch S1 and two-way switch S4 to switch on at the same time to form phase A; and controls the two-way switch S2 and two-way switch S3 to switch on at the same time to form phase B. Thus, by controlling the phase A and phase B to switch on alternately, a full-bridge circuit is formed;
2. When the full-bridge circuit operates, the energy in charge storage element C1 is transferred to the battery E through the third transformer T3 and rectifier circuit; and the rectifier circuit converts the AC input into DC and outputs the DC to the battery E, to attain the purpose of electricity recharge.

In another embodiment of the present invention, as shown in Figure 11, the energy limiting circuit for energy storage circuit can comprise the polarity inversion unit 102 and electricity recharge unit 103 described above; after the switch unit 1 switches off, the electricity recharge unit 103 transfers the energy in the charge storage element C1 to the battery E first, and then the polarity inversion unit 102 inverts voltage polarity of the charge storage element C1.

In another embodiment of the present invention, as shown in Figure 12, the energy control unit for energy storage circuit can comprises a DC-DC module 4, which is connected with the charge storage element C1 and the battery E respectively; the switching control module 100 is also connected with the DC-DC module 4, and is designed to transfer the energy in the charge storage element C1 to an energy storage element by controlling the operation of the DC-DC module 4 after the switch unit 1 switches on and then switches off., and then superpose the remaining energy in the charge storage element C1 with the energy in the battery E.

The DC-DC module 4 is a DC-DC (direct current to direct current) conversion circuit for energy transfer and voltage polarity inversion commonly used in the field. The present invention doesn't make any limitation to the specific circuit structure of the DC-DC module 4, as long as the module can accomplish energy transfer from the charge storage element C1 and voltage polarity inversion of the charge storage element C1. Those skilled in the art can add, substitute, or delete the elements in the circuit as required.

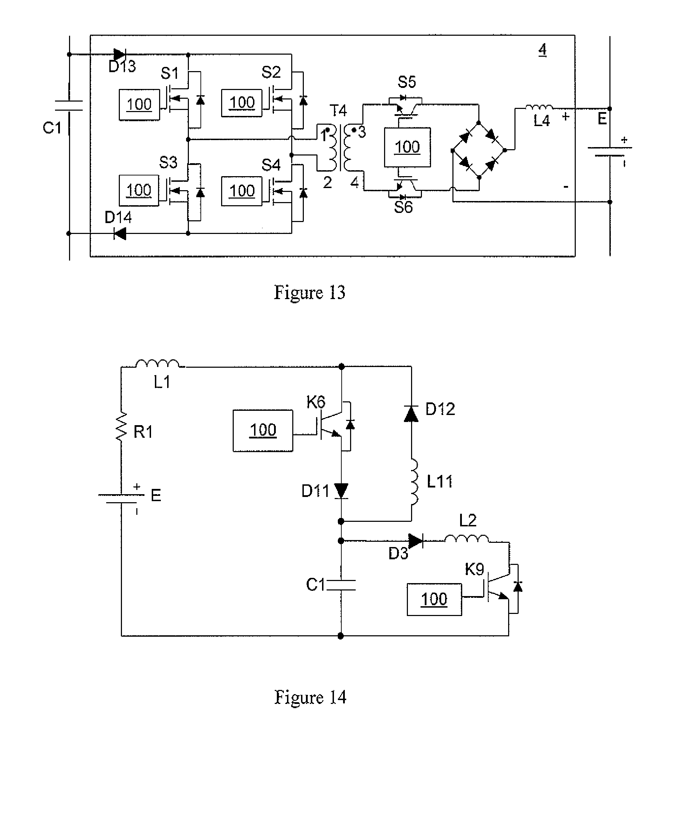

In an embodiment of the DC-DC module 4, as shown in Figure 13, the DC-DC module 4 comprises: a two-way switch S1, a two-way switch S2, a two-way switch S3, a two-way switch S4, a two-way switch S5, a two-way switch S6, a fourth transformer T4, an one-way semiconductor element D13, an one-way semiconductor element D14, a current storage element L4, and four one-way semiconductor elements. In that embodiment, the two-way switch S1, two-way switch S2, two-way switch S3, and two-way switch S4 are MOSFETs, while the two-way switch S5 and two-way switch S6 are IGBTs.

Wherein, the pin 1 and pin 3 of the fourth transformer T3 are dotted terminals; the negative electrodes of two one-way semiconductor elements among the four one-way semiconductor elements are connected into a group and their junction point is connected with the positive pole of the battery E through the current storage element L4; the positive electrodes of the other two one-way semiconductor elements are connected into a group and their junction point is connected with the negative pole of the battery E; in addition, the junction points between the groups are connected with pin 3 and pin 4 of the third transformer T3 via two-way switch S5 and two-way switch S6 respectively, and thereby form a bridge rectifier circuit.

Wherein, the source electrode of the two-way switch S1 is connected with the drain electrode of the two-way switch S3, the source electrode of the two-way switch S2 is connected with the drain electrode of the two-way switch S4, the drain electrodes of the two-way switch S1 and two-way switch S2 are connected with the positive end of the charge storage element C1 via the one-way semiconductor element D13, the source electrodes of the two-way switch S3 and two-way switch S4 are connected with the negative end of the charge storage element C1 via the one-way semiconductor element D14; thus, a full-bridge circuit is formed.

In the full-bridge circuit, the two-way switch S1 and two-way switch S2 constitute the upper bridge arm, and the two-way switch S3 and two-way switch S4 constitute the lower bridge arm; the pin 1 of the fourth transformer T4 is connected with the node between two-way switch S1 and two-way switch S3, and the pin 2 of the fourth transformer T4 is connected with the node between two-way switch S2 and two-way switch S4.

Wherein, the two-way switch S1, two-way switch S2, two-way switch S3, and two-way switch S4, two-way switch S5, and two-way switch S6 are controlled by the switching control module 100 respectively to switch on and switch off.

Hereafter the working process of the DC-DC module 4 will be described:
1. After the switch unit 1 switches off, when electricity recharging is to be performed from the charge storage element C1 (i.e., transferring the energy from the charge storage element C1 back to the battery E) so as to accomplish energy transfer, the switching control module 100 controls the two-way switch S5 and S6 to switch on, and controls the two-way switch S1 and two-way switch S4 to switch on at the same time, to constitute phase A; the switching control module 100 controls the two-way switch S2 and two-way switch S3 to switch on at the same time, to constitute phase B. Thus, by controlling the phase A and phase B to switch on alternately, a full-bridge circuit is formed;
2. When the full-bridge circuit operates, the energy in charge storage element C1 is transferred to the battery E through the fourth transformer T4 and rectifier circuit; the rectifier circuit converts the AC input into DC and outputs the DC to the battery E, to attain the purpose of electricity recharging;
3. When polarity inversion of the charge storage element C1 is to be performed to accomplish energy superposition, the switching control module 100 controls the two-way switch 55 and two-way switch S6 to switch off, and controls either of the two groups (two-way switch S1 and two-way switch S4, or two-way switch S2 and two-way switch S3) to switch on; now, the energy in the charge storage element C1 flows through the positive end of charge storage element C1, two-way switch S1, primary side of the fourth transformer T4, and two-way switch S4 back to the negative end of the charge storage element C1, or flows through the positive end of charge storage element C1, two-way switch S2, primary side of the fourth transformer T4, and two-way switch S3 back to the negative end of the charge storage element C1. Thus, the purpose of voltage polarity inversion of charge storage element C1 is attained by means of the magnetizing inductance at the primary side of T4.

The switching control module 100 can be a separate controller, which, by means of internal program setting, enables ON/OFF control of different external switches; or, the switching control module 100 can be a plurality of controllers, for example, a switching control module 100 can be set for each external switch correspondingly; or, the plurality of switching control modules 100 can be integrated into an assembly. The present invention does not define any limitation to the forms of implementation of the switching control module 100.

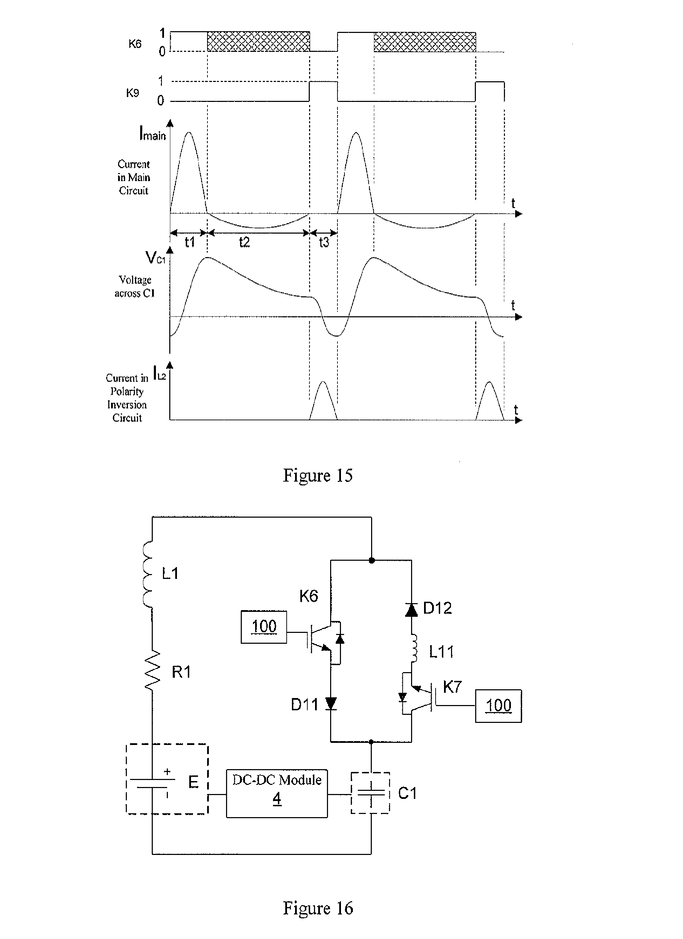

Hereafter the working process of the embodiments of the heating circuit for battery E will be described briefly with reference to Figures 14-16. It should be noted that, though the features and elements of the present invention are described specifically with reference to Figure 14 and Figure 16, each feature or element of the present invention can be used separately without other features and elements, or can be used in combination or not in combination with other features and elements. The embodiments of the heating circuit for battery E provided in the present invention are not limited to those shown in Figure 14 and 16. Figure 15 shows the wave pattern corresponding to the embodiment shown in Figure 14; the grid part of the wave pattern indicates drive pulses can be applied to the switch more times within the period, and the pulse width can be adjusted as required.

In the heating circuit for battery E shown in Figure 14, the switch K6 and one-way semiconductor element D11 are connected in series to constitute a first one-way branch of the switch unit; the one-way semiconductor element D12 constitutes the second one-way branch of the switch unit 1, the current storage element L11 is arranged in the second one-way branch as an energy limiting circuit, and is connected in series with the one-way semiconductor element D12, the one-way semiconductor element D3, current storage element 12, and switch K9 constitute an polarity inversion unit 102, the switching control module 100 can control ON/OFF of the switch K9 and K6. Figure 15 shows the wave pattern of the current Imain in the main loop of the heating circuit shown in Figure 14, voltage VC1 across C1, and current IL2 in the polarity inversion loop. The working process of the heating circuit shown in Figure 14 is as follows:
a) The switching control module 100 controls the switch K6 to switch on, and thus the battery E discharges in forward direction through the switch K6, one-way semiconductor element D11, and charge storage element C1 (as indicated by the time duration t1 shown in Figure 15), and is discharged in reverse direction through the current storage element L11 and one-way semiconductor element D12 (as indicated by the time duration t2 shown in Figure 15); it is seen from the time duration t2 in Figure 15 that, due to the existence of the current storage element L11, the current in the main loop is limited to a smaller value when the battery is charged;
b) The switching control module 100 controls the switch K6 to switch off when the current in reverse direction is zero.
c) The switching control module 100 controls the switch K9 to switch on, and therefore the polarity inversion unit 102 starts to operate; the charge storage element C1 discharges through the loop composed by the one-way semiconductor element D3, current storage element L2, and switch K9, to attain the purpose of voltage polarity inversion; then, the switching control module 100 controls the switch K9 to switch off, as indicated by the time duration t3 shown in Figure 15.
d) Repeat step a) to step c), the battery E is heated up continuously while it discharges and is charged, till the battery E meets the heating stop condition.

In the heating circuit for battery E shown in Figure 16, switch K6 and one-way semiconductor element D11 connected to each other in series (the first one-way branch) and switch K7 and one-way semiconductor element D12 connected to each other in series (the second one-way branch) constitute the switch unit 1; the current storage element L11 serves as the energy limiting circuit and is connected in series between the switch K7 and the one-way semiconductor element D12; the DC-DC module 4 constitutes an energy control unit for energy storage circuit, which transfers the energy in the charge storage element C1 back to the battery E, and then inverts the voltage polarity of the charge storage element C1, so that the energy in the charge storage element C1can be superposed with the energy in the battery E in the next charge/discharge cycle; the switching control module 100 can control ON/OFF of the switch K6 and K7 and can control whether the DC-DC module 4 operates or not. The working process of the heating circuit shown in Figure 16 is as follows:
a) The switching control module 100 controls the switch K6 and K7 to switch on, and thus the battery E discharges in forward direction through the switch K6, one-way semiconductor element D11, and charge storage element C1, and is charged in reverse direction through the charge storage element C1, switch K7, and one-way semiconductor element D12; due to the existence of the current storage element L11, the current in the main loop is limited to a smaller value when the battery E is charged;
b) The switching control module 100 controls the switch K6 and switch K7 to switch off when the current in reverse direction is zero;
c) The switching control module 100 controls the DC-DC module 4 to start to operate, the charge storage element C1 converts the AC current into DC current and outputs the DC current to the battery E via the DC-DC module 4, to accomplish electricity recharging; then, the DC-DC module 4 inverts the voltage polarity of the charge storage element C1; after the polarity inversion of C1, the switching control module 100 controls the DC-DC module 4 to stop operating;
d) Repeat step a) to step c), the battery E is heated up continuously while it discharges, till the battery E meets the heating stop condition.

Using the heating circuit provided in the present invention, safety problem related with short circuit caused by failures of the switch unit 1 can be avoided when the battery E is heated due to the existence of the charge storage element C1 connected in series, and therefore the battery E can be protected effectively.

While some preferred embodiments of the present invention are described above with reference to the accompanying drawings, the present invention is not limited to the details in those embodiments. Those skilled in the art can make modifications and variations to the technical solution of the present invention, without departing from the spirit of the present invention. However, all these modifications and variations shall be deemed as falling into the scope of the present invention.

In addition, it should be noted that the specific technical features described in above embodiments can be combined in any appropriate form, provided that there is no conflict. To avoid unnecessary repetition, the possible combinations are not described specifically in the present invention. Moreover, the different embodiments of the present invention can be combined freely as required, as long as the combinations do not deviate from the ideal and spirit of the present invention. However, such combinations shall also be deemed as falling into the scope disclosed in the present invention.

## Claims

1. A battery heating circuit, comprising a switch unit (1), a switching control module (100), a damping element R1, an energy storage circuit, an energy limiting circuit, and an energy control unit for energy storage circuit, wherein, the energy storage circuit is connected with the battery, and comprises a current storage element L1 and a charge storage element C1; the damping element R1, switch unit (1), current storage element L1, and charge storage element C1 are connected in series; the switching control module (100) is connected with the switch unit (1), and is designed to control ON/OFF of the switch unit (1), so that the energy can flow to and fro between the battery and the energy storage circuit when the switch unit (1) switches on; the energy limiting circuit is designed to limit the magnitude of current flowing from the energy storage circuit to the battery; the energy control unit for energy storage circuit is connected with the energy storage circuit, and is designed to control the energy conversion in the energy storage circuit to a preset value after the switching control module (100) controls the switch unit (1) to switch on and then switch off.

2. The heating circuit according to Claim 1, wherein, the damping element R1 is the parasitic resistance in the battery, and the current storage element L1 is the parasitic inductance in the battery.

3. The heating circuit according to Claim 1, wherein, the switch unit (1) comprises a first one-way branch designed to enable energy flow from the battery to the energy storage circuit and a second one-way branch designed to enable energy flow from the energy storage circuit to the battery; the switching control module (100) is connected to either or both of the first one-way branch and second one-way branch, and is designed to control ON/OFF of the switch unit (1) by controlling ON/OFF of the connected branches.

4. The heating circuit according to Claim 3, wherein, the energy limiting circuit comprises a current storage element L11 connected in series in the second one-way branch.

5. The heating circuit according to Claim 4, wherein, the switch unit (1) comprises a switch K6, a one-way semiconductor element D11, and a one-way semiconductor element D12, the switch K6 and the one-way semiconductor element D11 are connected with each other in series to constitute the first one-way branch; the one-way semiconductor element D12 constitutes the second one-way branch; the switching control module (100) is connected with the switch K6, and is designed to control ON/OFF of the first one-way branch by controlling ON/OFF of the switch K6, the current storage element L11 is connected in series with the one-way semiconductor element D12.

6. The heating circuit according to Claim 5, wherein, the switch unit (1) further comprises a switch K7, and the switch K7 is connected with the one-way semiconductor element D12 in series in the second one-way branch; the switching control module (100) is further connected with the switch K7, and is designed to control ON/OFF of the second one-way branch by controlling ON/OFF of the switch K7, the current storage element L11 is connected in series between the one-way semiconductor element D12 and the switch K7.

7. The heating circuit according to Claim 1, wherein, the energy control unit for energy storage circuit comprises a polarity inversion unit (102), which is connected with the energy storage circuit, and is designed to invert the voltage polarity of the charge storage element C1 after the switch unit (1) switches on and then switches off.

8. The heating circuit according to Claim 7, wherein, the energy control unit for energy storage circuit further comprises a electricity recharge unit (103), which is connected with the energy storage circuit, and is designed to transfer the energy in the energy storage circuit to the battery after the switch unit (1) switches on and then switches off and before the polarity inversion unit (102) inverts the voltage polarity of the charge storage element C1.

9. The heating circuit according to any of claims 7 or 8, wherein, the polarity inversion unit (102) comprises a single pole double throw switch J1 and a single pole double throw switch J2 located on the two ends of the charge storage element C1 respectively; the input wires of the single pole double throw switch J1 are connected in the energy storage circuit, the first output wire of the single pole double throw switch J1 is connected with the first pole plate of the charge storage element C1, and the second output wire of the single pole double throw switch J1 is connected with the second pole plate of the charge storage element C1; the input wires of the single pole double throw switch J2 are connected in the energy storage circuit, the first output wire of the single pole double throw switch J2 is connected with the second pole plate of the charge storage element C1, and the second output wire of the single pole double throw switch J2 is connected with the first pole plate of the charge storage element C1; the switching control module (100) is also connected with the single pole double throw switch J1 and single pole double throw switch J2 respectively, and is designed to invert the voltage polarity of the charge storage element C1 by altering the connection relationships between the respective input wires and output wires of the single pole double throw switch J1 and the single pole double throw switch J2.

10. The heating circuit according to any of claims 7 or 8, wherein, the polarity inversion unit (102) comprises a one-way semiconductor element D3, a current storage element L2, and a switch K9; the charge storage element C1, current storage element L2, and switch K9 are connected sequentially in series to form a loop; the one-way semiconductor element D3 is connected in series between the charge storage element C1 and the current storage element L2 or between the current storage element L2 and the switch K9; the switching control module (100) is also connected with the switch K9, and is designed to invert the voltage polarity of the charge storage element C1 by controlling the switch K9 to switch on.

11. The heating circuit according to any of claims 7 or 8, wherein, the polarity inversion unit (102) comprises a first DC-DC module (2) and a charge storage element C2; the first DC-DC module (2) is connected with the charge storage element C1 and the charge storage element C2 respectively; the switching control module (100) is also connected with the first DC-DC module (2), and is designed to transfer the energy in the charge storage element C1 to the charge storage element C2 by controlling the operation of the first DC-DC module (2), and then transfer the energy in the charge storage element C2 back to the charge storage element C1, so as to invert the voltage polarity of the charge storage element C1.

12. The heating circuit according to Claim 1, wherein, the energy control unit for energy storage circuit further comprises an electricity recharge unit (103), which is connected with the energy storage circuit, and is designed to transfer the energy in the energy storage circuit to the battery after the switch unit (1) switches on and then switches off.

13. The heating circuit according to any of claims 8 or 12, wherein, the electricity recharge unit (103) comprises a second DC-DC module (3), which is connected with the charge storage element C1 and the battery respectively; the switching control module (100) is also connected with the second DC-DC module (3), and is designed to transfer the energy in the charge storage element C1 to the battery by controlling the operation of the second DC-DC module (3).

14. The heating circuit according to claim 1, wherein, the energy control unit for energy storage circuit further comprises a DC-DC module (4), which is connected with the charge storage element C1 and the battery respectively; the switching control module (100) is also connected with the DC-DC module (4), and is designed to control the operation of the DC-DC module (4) to transfer the energy in the charge storage element C1 to the energy storage element, and then superpose the remaining energy in the charge storage element C1 with the energy in the battery after the switch unit (1) switches on and then switches off.

15. The heating circuit according to any of Claims 7, 8, 12 and 14, wherein, the switching control module (100) is designed to control the switch unit (1) to switch off when or after the current flow through the switch unit (1) reaches to zero after the switch unit (1) switches on.
